# EUROPEAN PATENT SPECIFICATION

(11) **EP 4 297 073 B1**
(45) Date of publication and mention of the grant of the patent: **28.10.2026**
(21) Application number: 23179284.7
(22) Date of filing: 14.06.2023
(51) Int. Cl.: H10P 72/00, H10P 72/30

(54) **SUBSTRATE TREATING APPARATUS**
VORRICHTUNG ZUR BEHANDLUNG VON SUBSTRATEN
APPAREIL DE TRAITEMENT DE SUBSTRAT

(30) Priority: 22.06.2022 JP 2022100314
(43) Date of publication of application: 27.12.2023
(73) Proprietor: SCREEN Holdings Co., Ltd., Kyoto-shi, Kyoto 602-8585 (JP)
(72) Inventor: MAEGAWA, Tadashi, Kyoto-shi, 602-8585 (JP)
(74) Representative: Kilian Kilian & Partner mbB

(56) References cited:
- US-A1- 2015 332 940
- US-A1- 2022 172 966

## Description

### BACKGROUND OF THE INVENTION

### Field of the Invention

The present invention relates to a substrate treating apparatus for performing predetermined treatment on a substrate, such as a semiconductor substrate, a substrate for flat panel display (FPD) like liquid crystal display and organic electroluminescence (EL) display, a glass substrate for photomask, and an optical disk substrate.

### Description of the Related Art

Such currently-used types of devices include one having a batch-type module, a single-wafer-type module, and a rotating mechanism. See, for example, Japanese Patent Publication (Translation of PCT Application) JP 2016-502275 A. The batch-type module performs treatment on a plurality of substrates collectively. The single-wafer-type module performs treatment on substrates one by one. Typically, dry treatment performed by the single-wafer-type module is better in particle performance than dry treatment performed by the batch-type module, since the treatment atmosphere affecting the substrate is smaller in space. Accordingly, the single-wafer-type module achieves more enhanced dry performance than the batch-type module. Then, an etching treatment and a rinse treatment are performed with the batch-type module, and thereafter, a dry treatment is performed with the single-wafer-type module, for example.

In the batch-type module, treatment is performed in such a state where the substrates are in a vertical posture. On the other hand, in the single-wafer-type module, the treatment is performed in such a state where the substrates are in a horizontal posture. Accordingly, the rotating mechanism turns the substrates in the vertical posture after the treatment by the batch-type module to the horizontal posture before the substrates are transported to the single-wafer-type module.

In recent years, patterns of a three-dimensional structure have become refined increasingly in the semiconductor field. Consequently, the patterns of such substrates as above may collapse due to an effect of a gas-liquid interface when the substrates are dried. Therefore, after the treatment with the batch-type module, the substrates are made wet for not being dried until the treatment with the single-wafer-type module is performed.

Specifically, a plurality of spray tubes are provided in the vicinity of the rotating mechanism. The spray tubes spray deionized water to the substrates held by the rotating mechanism. This makes the substrates, held by the rotating mechanism, wet until being placed on the single-wafer-type module.

However, the example of the currently-used apparatus with such a construction has the following drawbacks.

That is, the currently-used apparatus has a drawback that a positional relationship between the posture of the substrates held by the rotating mechanism and the spray tubes may generate time where the substrates are not sufficiently wet entirely. In addition, even when deionized water is sprayed from a position near the rotating mechanism, the substrates cannot be made wet sufficiently entirely since the rotating mechanism includes members. This leads to insufficient control in drying the substrates. Accordingly, such a drawback also arises that pattern collapse cannot be suppressed satisfactorily even if the dry treatment is performed with the single-wafer-type module having excellent dry performance.

Further prior art is US 2022/172966 A1 which is directed on a substrate treating apparatus for performing liquid treatment on a plurality of substrates with higher throughput of the substrate treatment with a posture changing member and a lifting/lowering member that may move a storage container in an up/down direction.

### SUMMARY OF THE INVENTION

The present invention has been made regarding the state of the art noted above, and its one object is to provide a substrate treating apparatus that allows suppressed pattern collapse in a substrate by making the substrate constantly wet entirely when a posture of the substrate is turned.

This object is achieved by the subject matter of the independent claim 1.

The invention is defined by the independent claim 1. Preferred embodiments are the subject matter of the dependent claims. Aspect of the invention are set out below. One aspect of the present invention provides a substrate treating apparatus that performs treatment on a substrate. The apparatus includes: a batch-type processing unit configured to perform treatment on a plurality of substrates in a vertical posture collectively; a single-wafer-type processing unit configured to perform treatment on one substrate of the substrates in a horizontal posture; a posture turning unit configured to hold the substrates on which the treatment is performed by the batch-type processing unit, and to turn a posture of the substrates from vertical to horizontal; A first transport unit configured to transport the substrates, on which the treatment is performed by the batch-type processing unit, to the posture turning unit; a second transport unit configured to transport the substrates, turned to horizontal by the posture turning unit, to the single-wafer-type processing unit; and an immersion tank configured to accommodate the substrates whose posture is to be turned by the posture turning unit, and in which the substrates are immersed in deionized water before the posture is turned.

With the aspect of the present invention, the substrates on which the treatment is performed by the batch-type processing unit are transported to the posture turning unit by the first transport unit. At this time, the substrates are immersed in the deionized water in the immersion tank until the posture thereof is turned. Accordingly, the substrates can entirely be made wet constantly when the posture thereof is turned from the vertical posture to the horizontal posture. As a result, pattern collapse in the substrates can be suppressed even when the substrates are transported to the single-wafer-type processing unit by the second transport unit and performs treatment.

It is preferred in the aspect of the present invention that the substrate treating apparatus further includes a lifting mechanism configured to move the substrates in the horizontal posture upward and downward relative to the immersion tank, and that only a target substrate to be transported among the substrates is moved above a liquid level of the immersion tank when the second transport unit receives the substrate to be transported.

The substrates not to be transported by the second transport unit are positioned below the liquid level of the immersion tank. Accordingly, the substrates can be prevented from being dried until the substrates are to be transported by the second transport unit. This results in suppressed pattern collapse of the substrates.

It is preferred in the aspect of the present invention that the posture turning unit includes an in-tank carrier configured to accommodate the substrates in such a manner that faces of the substrates are directed orthogonal with respect to a predetermined alignment direction and a rotating mechanism configured to rotate the in-tank carrier around a horizontal axis orthogonal with respect to the alignment direction under the liquid level of the immersion tank.

Since the in-tank carrier is rotated by the rotating mechanism, defacement in the in-tank carrier may be recovered by replacing the in-tank carrier only. This can shorten downtime, leading to expected enhancement of availability.

It is preferred in the aspect of the present invention that the lifting mechanism includes a lifter having a back plate extending along an inner surface of the immersion tank and a supporting portion provided at a lower end of the back plate along a horizontal direction and configured to support the in-tank carrier, and that the lifter moves among a sinking position where the in-tank carrier is entirely supported under the liquid level of the immersion tank, a rotating position, below the sinking position, where the supporting portion is spaced apart from a lower face of the in-tank carrier, a delivery position where the substrates are delivered to and from the first transport unit, and a transport position where only the target substrate to be transported is located above the liquid level of the immersion tank.

The lifting mechanism moves the lifter among the sinking position, the rotating position, the delivery position, and the transport position. Accordingly, the substrates can all be immersed in the deionized water, and can be turned to the horizontal posture under the liquid level. The substrate can be delivered to the first transport unit, and can be transported to the second transport unit.

It is preferred in the aspect of the present invention that the rotating mechanism includes one-paired rotary shafts that are movable between a connecting position where the one-paired rotary shafts are connected to a side face of the in-tank carrier orthogonal to the alignment direction and an opened position where the one-paired rotary shafts are spaced apart from the side face, and a rotation drive unit configured to rotate the one-paired rotary shafts at the connecting position to turn a posture of the substrates in the in-tank carrier.

The one-paired rotary shafts at the connecting position are rotated by the rotation drive unit, whereby the in-tank carrier can be rotated to turn the posture of the substrates to the horizontal posture collectively. Accordingly, the posture of the substrates can be turned with a simple configuration, leading to suppressed apparatus costs.

It is preferred in the aspect of the present invention that the substrate treating apparatus further includes an advancing and withdrawing drive mechanism configured to move the one-paired rotary shafts between the connecting position and the opened position, and that the rotation drive unit turns a posture of the substrates in the in-tank carrier while the advancing and withdrawing drive mechanism advances the one-paired rotary shafts to the connecting position and moves the lifter to the rotating position.

The rotation drive unit turns the posture of the substrates in the in-tank carrier while the advancing and withdrawing drive mechanism advances the one-paired rotary shafts to the connecting position and moves the lifter to the rotating position. Accordingly, the posture of the substrates can be turned without interference between the lifter and the in-tank carrier.

It is preferred in the aspect of the present invention that the in-tank carrier has an opening at a bottom face thereof, and that the lifter includes a pusher, the pusher being located at a position where the supporting portion does not close the opening, configured to support lower edges of the substrates, having a shape not interfering with the opening and the supporting portion, and configured to move upward and downward between a standby position below the in-tank carrier and at a bottom of the immersion tank and a transferring position, above the liquid level of the immersion tank, where the substrates are delivered to and from the first transport unit. When the first transport unit transports the substrates to the posture turning unit, the pusher is moved upward to the transferring position and receives the substrates, and thereafter the pusher is moved downward to the standby position and delivers the substrates to the in-tank carrier.

The substrates can be taken from the first transport unit while the pusher is moved upward to the transferring position. The pusher is moved downward to the standby position, whereby the substrates can be delivered to and from the in-tank carrier. Accordingly, upward and downward movement of the pusher achieves delivering of the substrates from the first transport unit to the in-tank carrier.

### BRIEF DESCRIPTION OF THE DRAWINGS

For **the purpose of illustrating the invention, there are shown in the drawings several forms which are presently preferred, it being understood, however, that the invention is not limited to the precise arrangement and instrumentalities shown.**
Fig. 1 is a plan view of a substrate treating apparatus according to one embodiment.
Fig. 2 is a plan view of an underwater posture turning unit.
Fig. 3 is a side view of the underwater posture turning unit.
Fig. 4 is a front view of the underwater posture turning unit.
Fig. 5 is an operational view of the underwater posture turning unit.
Fig. 6 is an operational view of the underwater posture turning unit.
Fig. 7 is an operational view of the underwater posture turning unit.
Fig. 8 is an operational view of the underwater posture turning unit.
Fig. 9 is an operational view of the underwater posture turning unit.
Fig. 10 is an operational view of the underwater posture turning unit.
Fig. 11 is an operational view of the underwater posture turning unit.
Fig. 12 is an operational view of the underwater posture turning unit.
Fig. 13 is a side view of an underwater posture turning unit according to one modification.

### DESCRIPTION OF THE PREFERRED EMBODIMENTS

Preferred examples of this invention will be described in detail hereinafter with reference to the drawings.

The following describes one embodiment of the present invention with reference to drawings.

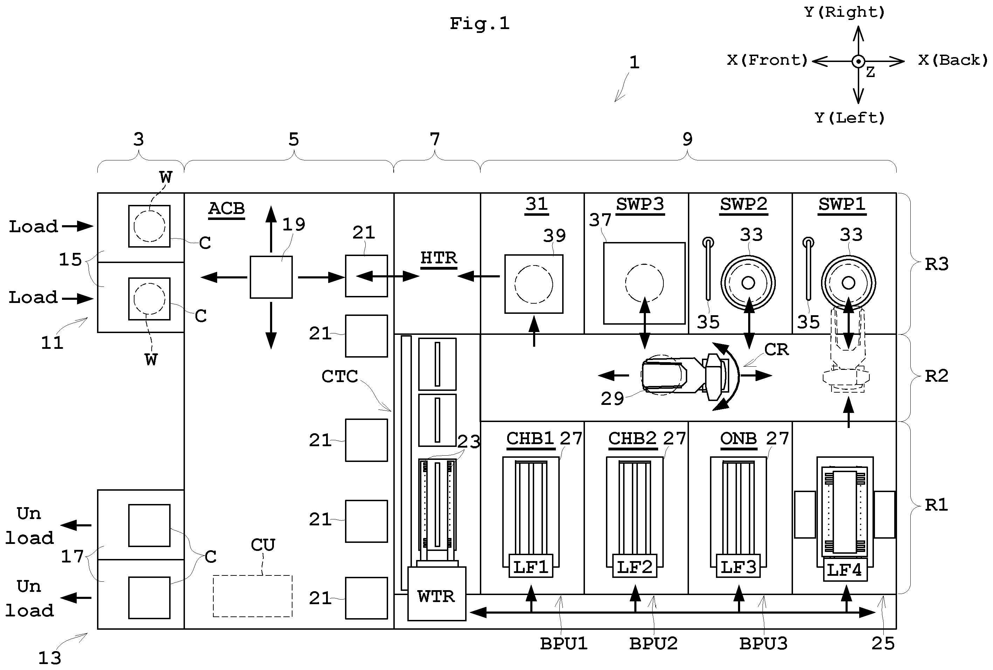

Fig. 1 is a plan view of a substrate treating apparatus according to one embodiment.

### <1. Overall Configuration>

A substrate treating apparatus 1 includes a loading and unloading block 3, a stocker block 5, a transferring block 7, and a treating block 9.

The substrate treating apparatus 1 treats substrates W. The substrate treating apparatus 1 performs chemical liquid treatment, cleaning treatment, dry treatment, and the like, for example, on the substrates W. The substrate treating apparatus 1 adopts a process system that combines a batch type and a single-wafer type (so-called hybrid type). In the batch type, treatment is performed on a plurality of substrates W in a vertical posture collectively. In the single-wafer type, treatment is performed on one substrate W in a horizontal posture.

In the present specification, the direction in which the loading and unloading block 3, the stocker block 5, the transferring block 7, and the treating block 9 are arranged is referred to as a "front-back direction X" for convenience. The front-back direction X is horizontal. One direction of the front-back direction X from the stocker block 5 to the loading and unloading block 3 is referred to as "forward". The direction opposite to the forward direction is referred to as "rearward". A horizontal direction orthogonal to the front-back direction X is referred to as a "transverse direction Y". Moreover, one direction of the transverse direction Y is referred to as "rightward", as appropriate. The direction opposite to the rightward direction is referred to as "leftward". The perpendicular direction relative to the horizontal direction is referred to as a "vertical direction Z". For reference, the drawings show front, rear, right, left, up, and down, as appropriate.

### <2. Loading and unloading block>

The loading and unloading block 3 includes a loading unit 11 and an unloading unit 13. The loading unit 11 and the unloading unit 13 are arranged in the transverse direction Y. A plurality of (e.g., twenty-five) substrates W are accommodated within one carrier C in a stack manner at uniform pitches in a horizontal posture. The carrier C accommodating untreated substrates W is placed on the loading unit 11. The loading unit 11 includes two mount tables 15, for example, on which the carrier C is placed. The carrier C has a plurality of grooves (not shown) formed therein for separating faces of the substrates W individually and accommodating the substrates W, respectively. Examples of the carrier C include a front opening unify pod (FOUP). The FOUP is a sealing container. The carrier C may be an opened container, whose type is not specified.

The unloading unit 13 is arranged opposite to the loading unit 11 across a center part of the substrate treating apparatus 1 in the transverse direction Y. The unloading unit 13 is arranged leftward Y of the loading unit 11. The unloading unit 13 loads the treated substrates W into the carrier C, and unloads the carrier C containing the substrates W. Similar to the loading unit 11, the unloading unit 13 functioning as above includes two mount tables 17, for example, on which the carrier C is placed. The loading unit 11 and the unloading unit 13 are also referred to as a load port.

### <3. Stocker block>

The stocker block 5 adjoints the rearward X of the loading and unloading block 3. The stocker block 5 includes a transporting and accommodating unit ACB. The transporting and accommodating unit ACB includes a transport mechanism 19 and shelves 21.

The transport mechanism 19 transports the carrier C. The transporting and accommodating unit ACB includes a plurality of shelves 21. There are two types of shelves 21, one of which the carrier C is simply placed on temporarily and the other of which the carrier C is placed on for delivery to and from a first transport mechanism HTR. The transporting and accommodating unit ACB takes the carrier C, in which untreated substrates W are housed, from the loading unit 11, and places the carrier C on the shelf 21. The transporting and accommodating unit ACB transports the carrier C to place the carrier C on a delivery shelf 21 in response to a schedule that defines an order of treatment. The transporting and accommodating unit ACB transports the empty carrier C placed on the delivery shelf 21 to place the empty carrier C on the shelf 21. The transporting and accommodating unit ACB transports the carrier C, placed on the delivery shelf 21 and in which the treated substrates W are housed by the first transport mechanism HTR, to place the carrier C on the shelf 21. The transporting and accommodating unit ACB unloads the carrier C, placed on the shelf 21 and in which the treated substrates W are housed, to the unloading unit 13.

### <4. Transferring block>

The transferring block 7 adjoints rearward X of the stocker block 5. The transferring block 7 includes the first transport mechanism HTR, a transferring mechanism CTC, and a second transport mechanism WTR.

The first transport mechanism HTR is arranged rightward Y and rearward X of the transporting and accommodating unit ACB. The first transport mechanism HTR transports substrates W collectively. In other words, the first transport mechanism HTR includes a plurality of hands (not shown). One of the hands supports one substrate W. The first transport mechanism HTR can transport only one substrate W. The first transport mechanism HTR collectively takes a plurality of (e.g., twenty-five) from the carrier C, placed on the delivery shelf 21 in the transporting and accommodating unit ACB, and transports the substrates W to the transferring mechanism CTC. At this time, the first transport mechanism HTR turns a posture of the substrates W from a horizontal posture to a vertical posture. The first transport mechanism HTR receives the treated substrates W collectively from the treating block 9, which is to be mentioned later. The first transport mechanism HTR transports the treated substrates W collectively to the carrier C placed on the delivery shelf 21 in the transporting and accommodating unit ACB.

The transferring mechanism CTC is arranged leftward Y of the first transport mechanism HTR. The transferring mechanism CTC delivers the substrates W between the first transport mechanism HTR and the second transport mechanism WTR. The transferring mechanism CTC transports the substrates W in the transverse direction Y between the first transport mechanism HTR and the second transport mechanism WTR. After receiving the substrates W from the first transport mechanism HTR, the transferring mechanism CTC moves to the second transport mechanism WTR in the transverse direction Y. At this time, the transferring mechanism CTC performs batch lot assemble or batch lot release. For example, the transferring mechanism CTC combines the substrates W constituting one lot taken out from one carrier C with the substrates W constituting another lot taken out from another carrier C as one batch lot. This corresponds to batch lot assemble. Operation reverse to this corresponds to batch lot release. That is, the substrates W constituting one lot of one batch lot are separated from the substrates W constituting another lot of the same batch lot to be returned to their original lots. Typically, pitches of substrates W taken out of a carrier C are equal to pitches of carriers C. This is called full-pitch. In one batch lot, pitches of the substrates W are half the full pitch, for example. This is called half-pitch. Here, since the present invention does not concern the pitch, detailed description of the pitch is to be omitted in the following description for easy understanding of the invention.

Now, the following description does not concern the construction of the lots to be treated. That is, there is no difference between the typical lot and the batch lot in the present invention, and thus a target to be treated is simply called a lot or a plurality of substrates W in the following description.

The second transport mechanism WTR is arranged leftward Y of the transferring mechanism CTC. The second transport mechanism WTR is configured to be movable between the transferring block 7 and the treating block 9. The second transport mechanism WTR is configured to be movable in the front-back direction X. The second transport mechanism WTR includes one-paired hands 23 configured to transport a lot. The one-paired hands 23 include rotary shafts, respectively, that extend in the transverse direction Y, for example. The one-paired hands 23 swing around the rotary shafts, respectively. The one-paired hands 23 grasp both edges of the substrates W constituting the lot. The second transport mechanism WTR delivers the substrates W to and from the transferring mechanism CTC. The second transport mechanism WTR delivers untreated substrates W to the treating block 9.

Here, the second transport mechanism WTR described above corresponds to the "first transport unit" in the present invention.

### <5. Treating block>

The treating block 9 performs treatment on the substrates W. Except for the second transport mechanism WTR, the treating block 9 is divided into a first line R1, a second line R2, and a third line R3 in the transverse direction Y. Specifically, the first line R1 is arranged leftward Y. The second line R2 is arranged in the middle in the transverse direction Y. In other words, the second line R2 is arranged rightward Y of the first line R1. The third line R3 is arranged rightward Y of the second line R2.

### <5-1. First line>

The first line R1 mainly includes a batch-type processing unit. Specifically, the first line R1 includes a first batch-type processing unit BPU1, a second batch-type processing unit BPU2, a third batch-type processing unit BPU3, and an underwater posture turning unit 25. The first batch processing unit BPU1 adjoints rearward X of the transferring block 7. The second batch processing unit BPU2 adjoints rearward X of the first batch processing unit BPU1. The third batch processing unit BPU3 adjoints rearward X of the second batch processing unit BPU2. An underwater posture turning unit 25 adjoints rearward X of the third batch processing unit BPU3.

Here, the first batch processing unit BPU1, the second batch processing unit BPU2, and the third batch processing unit BPU3 correspond to the "batch-type processing unit" in the present invention.

The first batch processing unit BPU1 is, for example, a chemical processing unit CHB1. The chemical processing unit CHB1 performs phosphoric acid treatment, for example. In the phosphoric acid treatment, phosphoric acid is used as a treatment liquid. In the phosphoric acid treatment, etching treatment is performed on a plurality of substrates W. In the etching treatment, a film thickness of a coating deposited on the substrate W is chemically ground, for example. The coating is, for example, nitride film.

The chemical processing unit CHB1 includes a process tank 27 and a lifter LF1. The process tank 27 stores a treatment liquid. The process tank 27 supplies the treatment liquid upward from the below, for example. The lifter LF1 moves upward and downward in the vertical direction Z. Specifically, the lifter LF1 moves upward and downward between a treating position inside of the process tank 27 and a delivery position above the process tank 27. The lifter LF1 holds a plurality of substrates W in a vertical posture. The lifter LF1 delivers the substrates W at the delivery position to and from the second transport mechanism WTR.

The second batch processing unit BPU2 is, for example, a chemical processing unit CHB2. The chemical processing unit CHB2 has a configuration similar to that of the chemical processing unit CHB1. That is, the chemical processing unit CHB2 includes another process tank 27 and a lifter LF2. The chemical processing unit CHB2 performs treatment similar to that performed by the chemical processing unit CHB1. That is, there is a plurality of treating units that performs the same chemical liquid treatment. This is because a longer period of time is needed for phosphoric acid treatment than other chemical liquid treatment and the deionized water cleaning treatment. For example, it takes around sixty minutes to perform the phosphoric acid treatment. Accordingly, the phosphoric acid treatment is performed in the processing units simultaneously, leading to enhanced throughput.

The third batch processing unit BPU3 is, for example, a deionized water processing unit ONB. The deionized water processing unit ONB has a configuration similar to those of the chemical processing units CHB1 and CHB2. That is, deionized water processing unit ONB includes another process tank 27 and a lifter LF3. However, the process tank 27 mainly receives deionized water for deionized water cleaning treatment. The process tank 27 of the deionized water processing unit ONB cleans the substrates W to which a chemical liquid is adhered. In other words, the process tank 27 of the deionized water processing unit ONB cleans off the chemical adhered to the substrates W. When specific resistance of the deionized water in the process tank 27 increases to a given value, for example, the deionized water processing unit ONB stops the cleaning treatment.

### <5-2. Second line>

The second line R2 includes a center robot CR. The center robot CR includes a hand 29. The hand 29 holds one substrate W. The center robot CR may adopt a configuration, for example, that includes another hand 29 in the vertical direction Z. The center robot CR is configured to be movable in the front-back direction X. The center robot CR is configured to be movable upward and downward in the vertical direction Z. The center robot CR is configured in such a manner as to be turnable in a horizontal plane including the front-back direction X and the transverse direction Y. The hand 29 is configured in such a manner as to be able to advance and withdraw in a horizontal plane including the front-back direction X and the transverse direction Y. The hand 29 receives substrates W one by one from the underwater posture turning unit 25. The center robot CR delivers substrates W one by one to the third line R3. Now, when the center robot CR includes two hands 29, the hands 29 receive two substrates W from the underwater posture turning unit 25 and deliver the substrates W to two positions, respectively, in the third line R3.

The center robot CR described above corresponds to the "second transport unit" in the present invention.

### <5-3. Third line>

The third line R3 mainly includes a single-wafer-type processing unit. Specifically, the third line R3 includes a first single-wafer processing unit SWP1, a second single-wafer processing unit SWP2, a third single-wafer processing unit SWP3, and a buffer unit 31. The first single-wafer processing unit SWP1 is arranged at the innermost side in the front-back direction X. In other words, the first single-wafer processing unit SWP1 is arranged opposite to the underwater posture turning unit 25 across the second line R2 in the transverse direction Y. The second single-wafer processing unit SWP2 adjoints forward X of the first single-wafer processing unit SWP1. The third single-wafer processing unit SWP3 adjoints forward X of the second single-wafer processing unit SWP2. The buffer unit 31 adjoints forward X of the third single-wafer processing unit SWP3 and rearward X of the first transport mechanism HTR.

Here, the first single-wafer processing unit SWP1, the second single-wafer processing unit SWP2, and the third single-wafer processing unit SWP3 correspond to the "single-wafer-type processing unit" in the present invention.

The first single-wafer processing unit SWP1 and the second single-wafer processing unit SWP2 each include, for example, a rotating unit 33 and a nozzle 35. The rotating unit 33 rotates the substrate W in a horizontal plane. The nozzle 35 supplies a treatment liquid to the substrate W. The nozzle 35 swings between a standby position apart from the rotating unit 33 and a supply position above the rotating unit 33. The treatment liquid is, for example, isopropyl alcohol (IPA) or deionized water. The first single-wafer processing unit SWP1 and the second single-wafer processing unit SWP2 each perform cleaning treatment on the substrate W with deionized water, and then perform preliminary dry treatment with IPA, for example.

The third single-wafer processing unit SWP3 includes, for example, a supercritical fluid chamber 37. The supercritical fluid chamber 37 performs dry treatment with supercritical fluid, for example. The fluid used at this time is, for example, carbon dioxide. The supercritical fluid chamber 37 performs treatment on the substrate W with the treatment liquid under a supercritical state. The supercritical state is obtained by bringing fluid into critical temperature and pressure inherent in the fluid. Specifically, when the fluid is carbon dioxide, a critical temperature is 31 degrees Celsius and critical pressure is 7.38 MPa. Under the supercritical state, the fluid has a surface tension of zero. Accordingly, patterns of the substrate W are not affected by a gas-liquid interface. Consequently, pattern collapse is unlikely to occur in the substrate W.

The buffer unit 31 includes, for example, a plurality of steps of mount shelves 39. The mount shelves 39 are preferably stacked in the vertical direction Z. At least one lot of substrates W can be placed in the mount shelves 39. Since the first transport mechanism HTR can take out the substrates W collectively, the first transport mechanism HTR has lower load than the case where the first transport mechanism HTR takes out the substrate W one by one. The buffer unit 31 is accessible from different horizontal directions. The center robot CR accesses the buffer unit 39 from a side adjacent to the second line R2 toward rightward Y to place the substrate W. The first transport mechanism HTR accesses the buffer unit 39 from frontward X to rearward X to receive one lot of the substrates W. The first transport mechanism HTR can also receive less than one lot of the substrates W. The center robot CR described above moves upward and downward to and from the mount shelves 39 in the vertical direction Z to deliver the substrates W.

It is preferable that, in the first single-wafer processing unit SWP1, the second single-wafer processing unit SWP2, and the third single-wafer processing unit SWP3, the processing units likewise are stacked in multiple steps in the vertical direction Z. This achieves enhanced throughput.

### <6. Underwater posture turning unit>

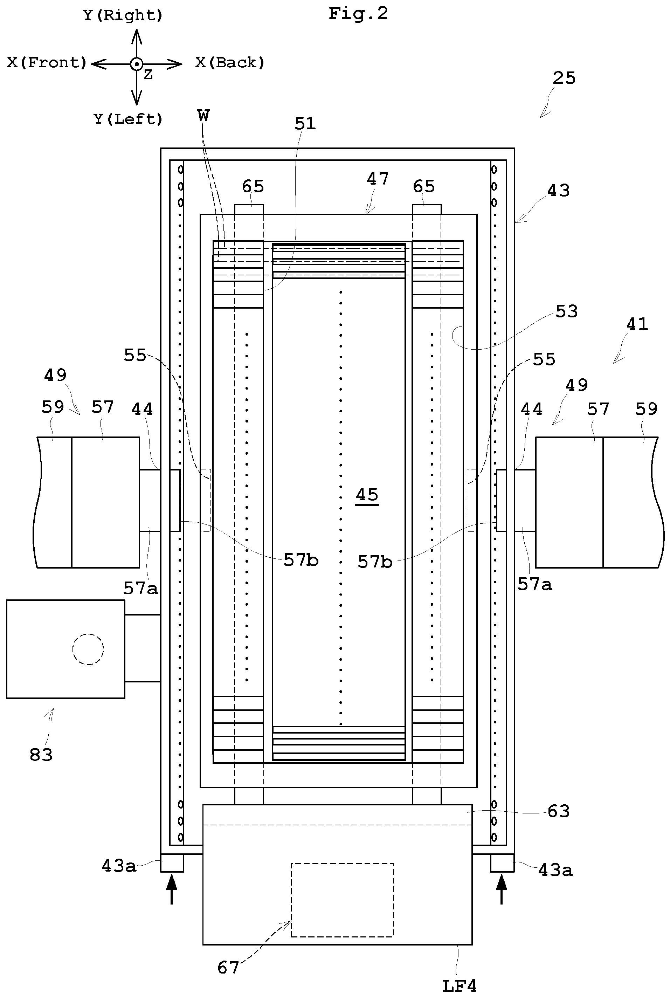

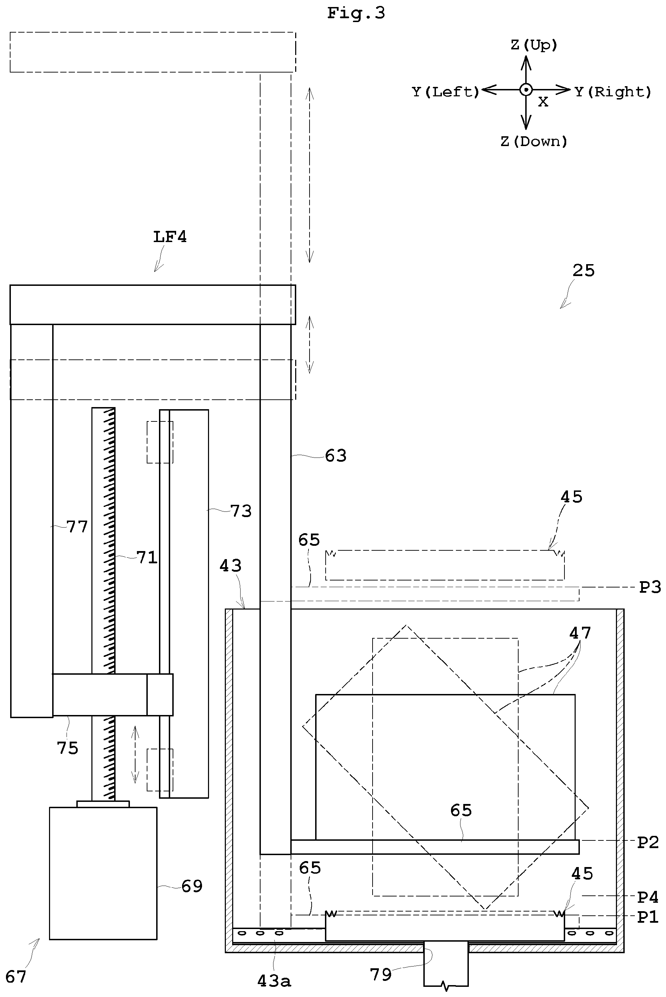

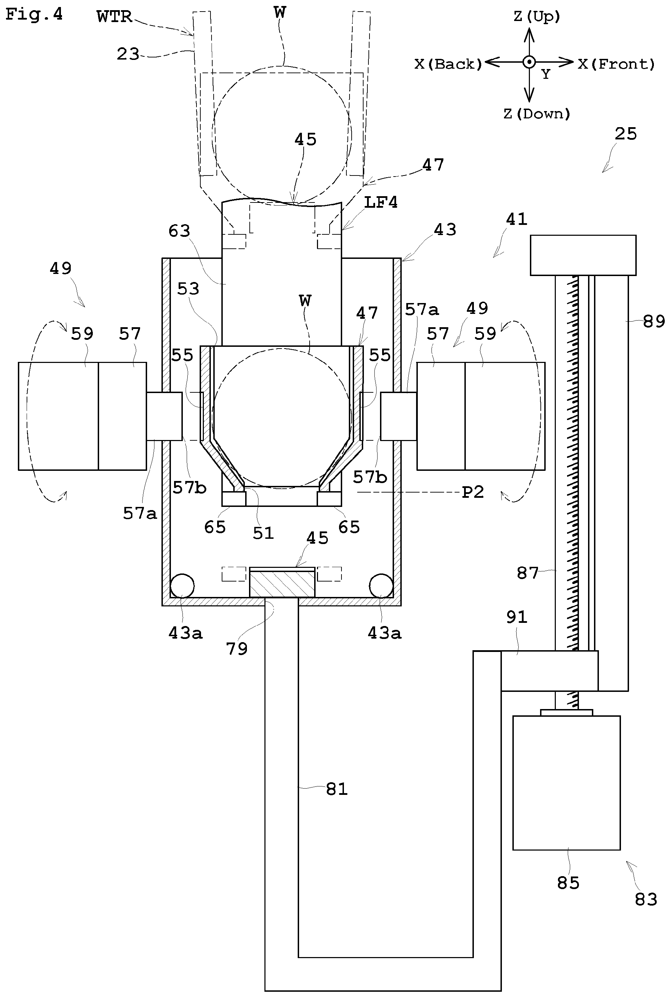

Now, description is made of the underwater posture turning unit with reference to Figs. 2 to 4. Fig. 2 is a plan view of the underwater posture turning unit. Fig. 3 is a side view of the underwater posture turning unit. Fig. 4 is a front view of the underwater posture turning unit.

The underwater posture turning unit 25 includes a posture turning unit 41, an immersion tank 43, a lifter LF4, and a pusher 45. The posture turning unit 41 includes an in-tank carrier 47 and a rotating mechanism 49.

The in-tank carrier 47 accommodates a plurality of substrates W in a vertical posture. The in-tank carrier 47 accommodates the substrates W at predetermined intervals along a predetermined alignment direction. The substrates W face a direction orthogonal to the alignment direction. Here in this embodiment, the alignment direction corresponds to the transverse direction Y. The in-tank carrier 47 has an opening 51 formed at the bottom thereof. The in-tank carrier 47 has an opening 53 formed at the top thereof. The opening 53 has a length in the front-back direction X longer than a diameter of the substrate W. The opening 51 is smaller than the opening 53 in its opening area. The in-tank carrier 47 includes engaging portions 55. The engaging portions 55 are formed in two outer surfaces of the in-tank carrier 47 in the front-back direction X. The engaging portions 55 are formed in the outer surfaces orthogonal to the alignment direction of the substrates W.

The immersion tank 43 accommodates the in-tank carrier 47. The immersion tank 43 includes jet pipes 43a at both sides of the bottom face thereof in the front-back direction X. The jet pipes 43a each have a tubular shape. The jet pipes 43a each have a long shaft in the transverse direction Y. The jet pipes 43a are each long in the transverse direction Y. The jet pipes 43a each supply deionized water to a center part of the immersion tank 43 in the front-back direction X. The jet pipes 43a each form an upward flow of the deionized water flowing upward from the bottom of the immersion tank 43. The deionized water supplied into the immersion tank 43 from the jet pipes 43a is discharged over an upper edge of the immersion tank 43.

The rotating mechanism 49 includes air cylinders 57 and a motor 59. The air cylinder 57 includes an operating shaft 57a and an engaging piece 57b. The operating shaft 57a advances and withdraws in the front-back direction X in response to on-off of the air cylinder 57. The immersion tank 43 has through holes 44 formed therein. The through holes 44 are formed in the side walls of the immersion tank 43 in the front-back direction X. The operating shaft 57a is attached to the through hole 44 of the immersion tank 43 in a liquid-tight manner. The operating shaft 57a can advance and withdraw in the front-back direction X in the liquid-tight manner. The operating shaft 57a can rotate around an axis in the front-back direction X in the liquid-tight manner. In other words, the operating shaft 57a can advance and withdraw and can also rotate relative to the center part of the immersion tank 43 in a maintained liquid-tight manner.

An advancing position of the engaging piece 57b of the operating shaft 57a for engaging the engaging portion 55 is a connecting position. A retracted position of the engaging piece 57b of the operating shaft 57a for spacing apart from the engaging portion 55 is an opened position. The operating shaft 57a shown in Fig. 2 has the engaging piece 57b in the opened position.

The engaging piece 57b engages the engaging portion 55 of the in-tank carrier 47. The engaging piece 57b has a shape (contour) of an outer circumferential surface so as to engage the engaging portion 55. The engaging portion 55 and the engaging piece 57b each have a polygon shape seen from the front-back direction X, for example. The engaging piece 57b is slightly smaller than the engaging portion 55 in dimension in the vertical cross-sectional shape. An inner circumferential surface shape of the engaging portion 55 is similar to an outer circumferential surface of the engaging piece 57b. The in-tank carrier 47 is integrated with the operating shaft 57a while the engaging piece 57b engages the engaging portion 55. In other words, the in-tank carrier 47 does not rotate around the axis in the front-back direction X with respect to the operating shaft 57a while the engaging piece 57b engages the engaging portion 55. The in-tank carrier 47 is rotatable together with the operating shaft 57a around the axis in the front-back direction X.

When the air cylinder 57 turns on, the operating shaft 57a advances, for example. When the air cylinder 57 turns off, the operating shaft 57a withdraws, for example. When the air cylinder 57 turns on, the air cylinder 57 moves to the connecting position where the engaging piece 57b engages the engaging portion 55. When the air cylinder 57 turns off, the air cylinder 57 moves to the opened position where the engaging piece 57b is spaced apart from the engaging portion 55. In the connecting position, the operating shaft 57a is integrated with the in-tank carrier 47. In the opened position, the operating shaft 57a is separated from the in-tank carrier 47.

Here, the two operating shafts 57a described above correspond to the "one-paired rotary shafts" in the present invention. The two air cylinders 57 described above correspond to the "advancing and withdrawing drive mechanism" in the present invention.

The motor 59 rotates the air cylinder 57 around the axis in the front-back direction X. When the air cylinder 57 turns on and the motor 59 drives in a first direction, the motor 59 causes the in-tank carrier 47 to rotate around the axis in the front-back direction X. When the air cylinder 57 turns on and the motor 59 drives in a second direction reverse to the first direction, the motor 59 causes the in-tank carrier 47 to rotate reversely around the axis in the front-back direction X. Rotation angles at this time are each around 90 degrees. The rotation angles at this time correspond to rotation angles where a posture of the substrates W accommodated in the in-tank carrier 47 turns between a horizontal direction and a vertical direction.

Here, the motor 59 described above corresponds to the "rotation drive unit" in the present invention. The motor 59 described above corresponds to the "rotating mechanism" in the present invention.

The lifter LF4 includes a back plate 63 and a supporting portion 65. The back plate 63 extends along an inner surface of the immersion tank 43. The back plate 63 extends at a lower part in the vertical direction Z of the inner surface in the front-back direction X. For example, two supporting portions 65 are attached to a lower end of the back plate 63. The two supporting portions 65 extend in the transverse direction Y. The two supporting portions 65 have a gap in the front-back direction X larger than the opening 51. The lifter LF4 supports the in-tank carrier 47 such that a longitudinal direction of the in-tank carrier 47 is made horizontal.

A lifting mechanism 67 is located near the lifter LF4. The lifting mechanism 67 includes a motor 69, a threaded shaft 71, a linear guide 73, and a lifting piece 75. The motor 69 is located in a posture where the rotary shaft thereof faces in a longitudinal direction. The threaded shaft 71 is attached to the rotary shaft of the motor 69. The threaded shaft 71 faces in the vertical direction Z. The linear guide 73 is provided parallel to the threaded shaft 71. The linear guide 73 is directed in the vertical direction Z. The lifting piece 75 is screwed on the threaded shaft 71. One end of the lifting piece 75 is slidably attached to the linear guide 73. The other end of the lifting piece 75 is attached to a connecting member 77. The connecting member 77 has an inverted L-shape. The connecting member 77 is coupled to an upper end of the back plate 63.

When the motor 69 is driven, the threaded shaft 71 is rotated. When the threaded shaft 71 is rotated, the lifting piece 75 is moved upward and downward in the vertical direction Z along the linear guide 73 in response to a rotation direction of the motor 69. This causes the lifter LF4, for example, to move upward and downward to a plurality of height positions.

For example, as shown in Fig. 3, the lifting mechanism 67 causes the lifter LF4 to move upward and downward among a first height position P1, a second height position P2, a third height position P3, and a fourth height position P4. The first height position P1 is lower than the second to fourth height positions P2 to P4. The second height position P2 is higher than the first height position P1 and the fourth height position P4, and lower than the third height position P3. The third height position P3 is higher than the first height position P1, the second height position P2, and the fourth height position P4. The fourth height position P4 is higher than the first height position P1 and higher than the second height position P2 and the third height position P3.

At the first height position P1, the supporting portion 65 of the lifter LF4 is positioned near the bottom face of the immersion tank 43. The first height position P1 is a position where the in-tank carrier 47 is grasped by the rotating mechanism 49 and the supporting portion 65 is spaced apart from the lower face of the in-tank carrier 47. The first height position P1 is a position where the in-tank carrier 47 is rotated vertically in the longitudinal direction within the immersion tank 43 by the rotating mechanism 49.

The second height position P2 is a position where the in-tank carrier 47 is entirely supported under a liquid level of the immersion tank 43. At the second height position P2, the opening 53 of the in-tank carrier 47 is positioned below the liquid level. The second height position P2 is a position where the rotating mechanism 49 grasps the in-tank carrier 47. At the second height position P2, the engaging portion 55 of the in-tank carrier 47 and the engaging piece 57b of the air cylinder 57 are aligned linearly in the horizontal direction. In other words, the second height position P2 is a position where the engaging portion 55 faces the engaging piece 57b in the horizontal direction.

The third height position P3 is a position where a plurality of substrates W are delivered between the second transport mechanism WTR and the in-tank carrier 47. At the third height position P3, the supporting portion 65 of the lifter LF4 is positioned above the liquid level of the immersion tank 43, for example. However, the supporting portion 65 is not necessarily positioned above the liquid level as long as the bottom of the in-tank carrier 47 is positioned above the liquid level.

At the fourth height position P4, the in-tank carrier 47 in which the substrates W are in a horizontal posture is kept under the liquid level of the immersion tank 43. A stepwise position from the fourth height position P4 to the third height position P3 corresponds to a height position where only substrates W to be transported by the center robot CR are located above the liquid level of the immersion tank 43.

Here, the first height position P1 described above corresponds to the "rotating position" in the present invention. The second height position P2 described above corresponds to the "sinking position" in the present invention. The third height position P3 described above corresponds to the "delivery position" in the present invention. The position from the fourth height position P4 to the third height position P3 described above correspond to the "transport position" in the present invention.

The immersion tank 43 has a through hole 79 formed in the bottom thereof. The lifting member 81 is inserted into the through hole 79. The lifting member 81 is inserted into the through hole 79 while the immersion tank 43 is kept in a liquid-tight manner. The lifting member 81 has a U-shape. A pusher 45 is attached to one end of the lifting member 81. The pusher 45 can support the substrates W collectively. The pusher 45 contacts and supports lower edges of the substrates W. As shown in Figs. 2 and 3, the pusher 45 has a dimension smaller than the openings 51 and 53 of the in-tank carrier 47. The pusher 45 can pass through the in-tank carrier 47 in the vertical direction Z to move upward and downward. The pusher 45 is narrower than the gap between the supporting portions 65 of the lifter LF4 in the front-back direction X. The pusher 45 does not interfere with the in-tank carrier 47 and the supporting portions 65 of the lifter LF4.

The pusher 45 includes a lifting mechanism 83 at a position near thereto. The lifting mechanism 83 includes a motor 85, a threaded shaft 87, a linear guide 89, and a lifting piece 91. The rotary shaft of the motor 85 is located in a longitudinal direction. The threaded shaft 87 is attached to the rotary shaft of the motor 85. The threaded shaft 87 is arranged in the vertical direction Z. The linear guide 89 is arranged in a positional relationship parallel to the threaded shaft 87. The linear guide 89 is arranged in the vertical direction Z. The lifting piece 91 is screwed on the threaded shaft 87. One end of the lifting piece 87 is slidably attached to the linear guide 89. The other end of the lifting piece 87 is connected to the lifting member 81.

When the motor 85 is driven forward or reverse, the threaded shaft 87 rotates in a forward direction or a reverse direction. The lifting piece 91 is moved upward and downward along the linear guide 89 in the vertical direction Z in response to a rotation direction of the motor 85. This causes the pusher 45 to move upward and downward in the vertical direction Z. The pusher 45 is moved upward and downward between a standby position and a transferring position. The standby position is below the in-tank carrier 47 and in the vicinity of the bottom of the immersion tank 43. This standby position is shown in Figs. 3 and 4 by solid lines. The transferring position is above the liquid level of the immersion tank 43. This transferring position is shown in Figs. 3 and 4 by chain double-dashed line. The transferring position is a position where a plurality of substrates W are delivered to and from the second transport mechanism WTR.

Here, since the in-tank carrier 47 is rotated by the rotating mechanism 49, defacement in the in-tank carrier 47 may be recovered by replacing the in-tank carrier 47 only. This can shorten downtime in the substrate treating apparatus 1, leading to expected enhancement of availability.

A controller CU controls en bloc each element of the apparatus mentioned above. The controller CU includes a CPU and a memory. The controller CU operates each component in response to programs stored in advance in the memory to perform treatment on the substrates W.

### <7. Operation explanation>

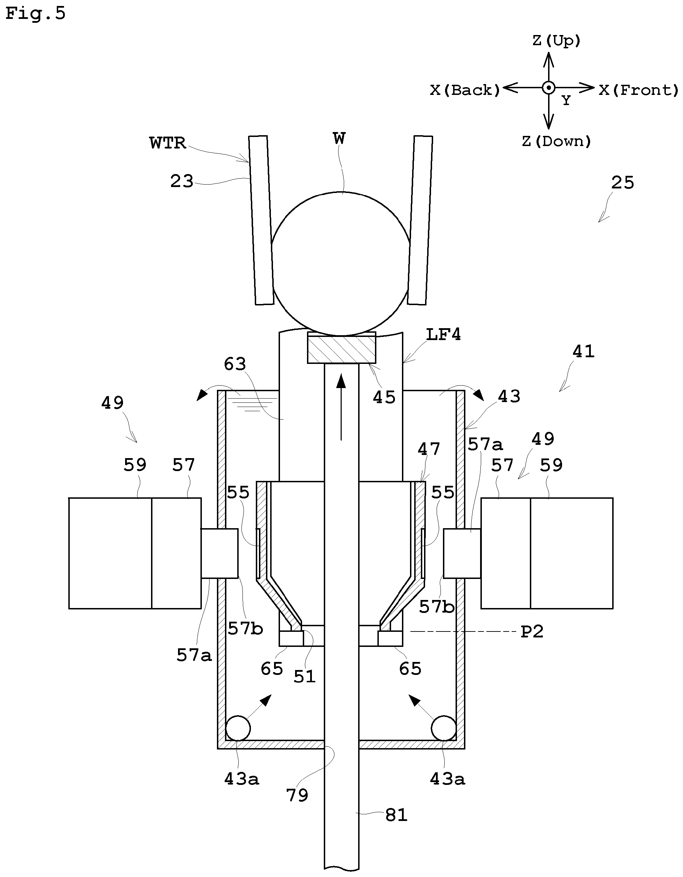

The following describes operation of the underwater posture turning unit 25 in the substrate treating apparatus 1 described above with reference to Figs. 5 to 12. Figs. 5 to 12 are each an operational view of the underwater posture turning unit.

### <7-1. Batch treatment>

It is assumed that a plurality of substrates W are subjected to an etching treatment with phosphoric acid in the chemical processing unit CHB1, and then subjected to a deionized water treatment in the deionized water processing unit ONB. The substrates W on which the deionized water cleaning treatment is performed are transported to the underwater posture turning unit 25 by the second transport mechanism WTR.

### <7-2. Posture turning>

Reference is made to Fig. 5. The second transport mechanism WTR grasps the substrates W, on which the treatment is performed by the deionized water cleaning treatment in the deionized water processing unit ONB, with the hands 23, and transports the substrates W to the above of the underwater posture turning unit 25. At this time, in the underwater posture turning unit 25, the supporting portions 65 of the lifter LF4 are positioned at the second height position P2. The in-tank carrier 47 is supported by the supporting portions 65. The jet pipe 43a supplies deionized water into the immersion tank 43 in up-flow. The deionized water flows out of the upper edge of the immersion tank 43. Accordingly, the immersion tank 43 is constantly filled with clean deionized water. In the rotating mechanism 49, the engaging piece 57b of the operating shaft 57a is in the opened position. That is, the rotating mechanism 49 is spaced apart from the in-tank carrier 47. The pusher 45 is moved upward from the standby position in the immersion tank 43 to the transferring position. Accordingly, the pusher 45 contacts and supports lower edges of the substrates W held by the second transport mechanism WTR.

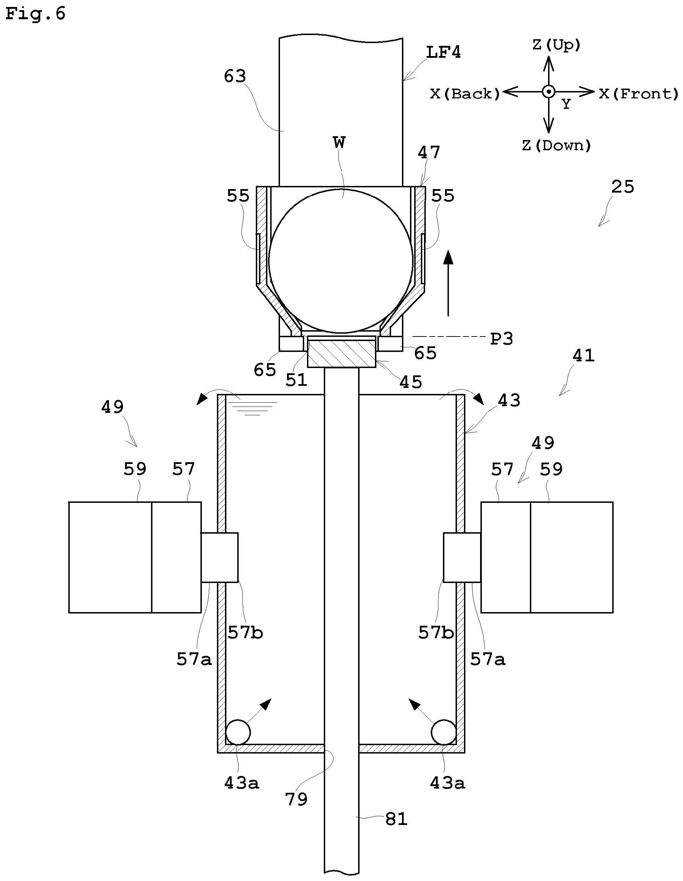

Reference is made to Fig. 6. The second transport mechanism WTR releases grasp of the hands 23 to the substrates W, and releases the substrates W. Accordingly, the substrates W are delivered from the second transport mechanism WTR to the pusher 45. Then, the second transport mechanism WTR retreats from the above of the underwater posture turning unit 25. Specifically, the second transport mechanism WTR moves to the first batch processing unit BPU1.

The lifting mechanism 67 drives the motor 69 to move the lifter LF4 upward to the delivery position. Specifically, the lifter LF4 is moved upward to the third height position P3. Accordingly, the substrates W whose lower edges are supported by the pusher 45 are accommodated in the in-tank carrier 47.

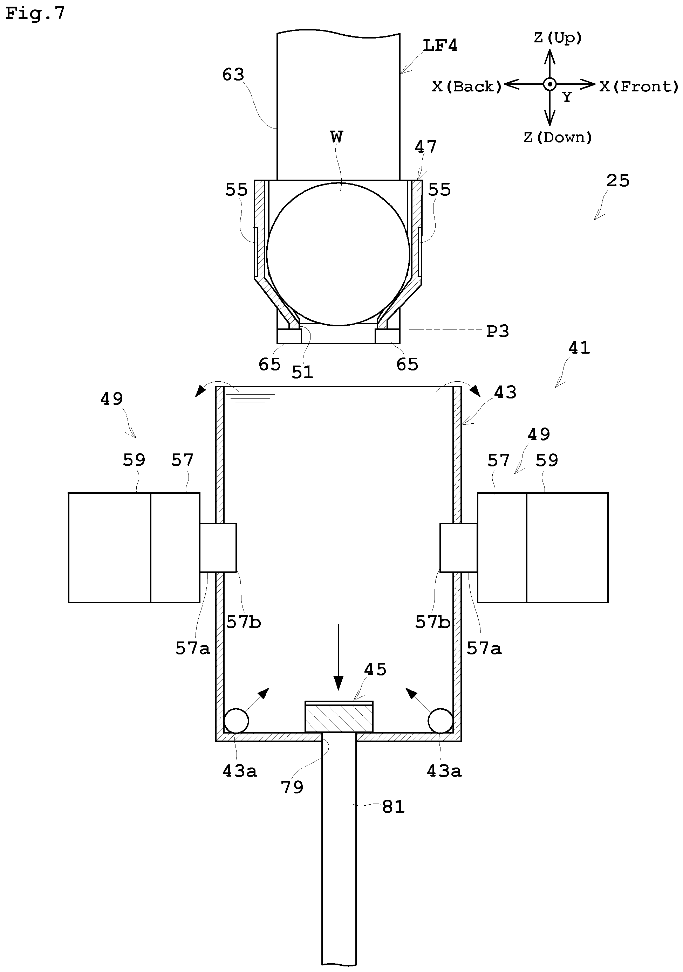

Reference is made to Fig. 7. The lifting mechanism 83 drives the motor 85 to move the pusher 45 downward to the standby position. Accordingly, the substrates W are completely accommodated in the in-tank carrier 47.

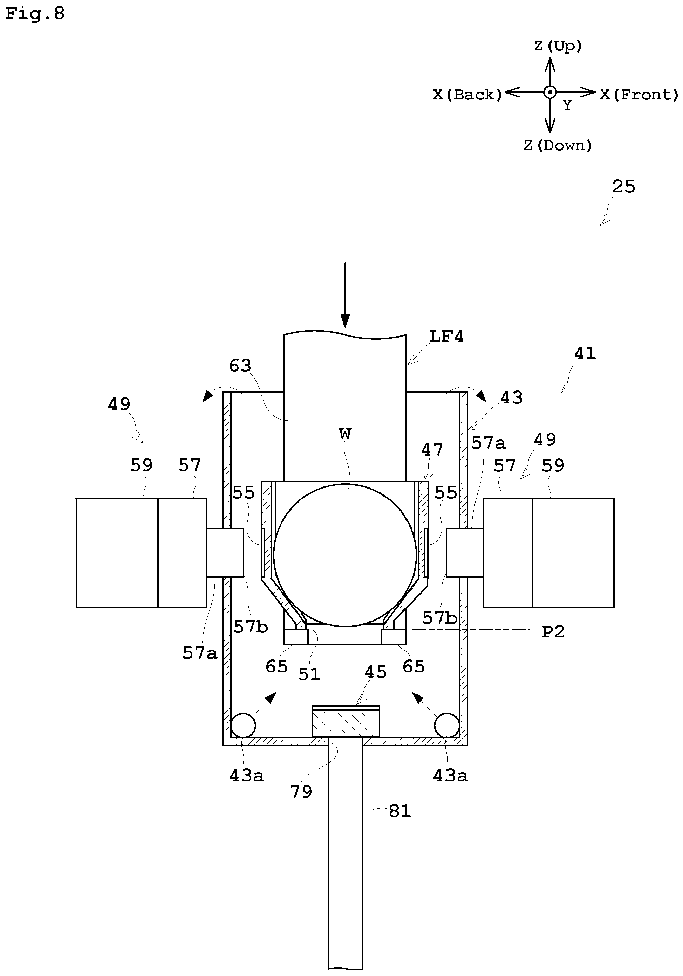

Reference is made to Fig. 8. The lifting mechanism 67 drives the motor 69 to move the lifter LF4 downward to the second height position P2.

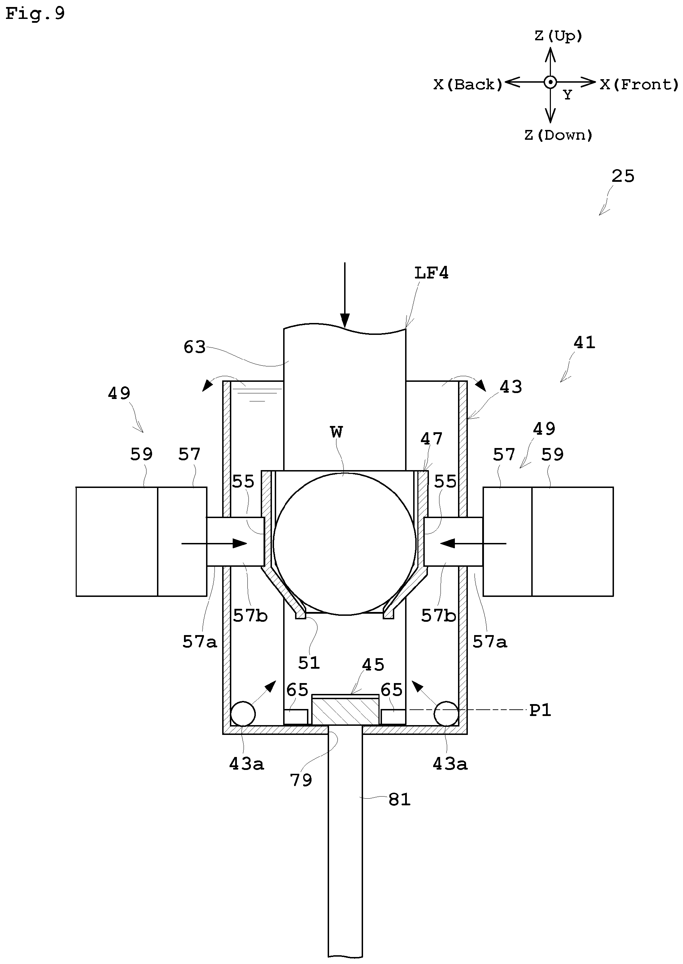

Reference is made to Fig. 9. The rotating mechanism 49 actuates the air cylinder 57 to advance the operating shaft 57a into the in-tank carrier 47. The rotating mechanism 49 causes the operating shaft 57a to advance to the connecting position. Accordingly, the engaging piece 57b of the air cylinder 57 engages the engaging portion 55 of the in-tank carrier 47. The in-tank carrier 47 is grasped by the one-paired operating shafts 57a while the lower part thereof is supported by the lifter LF4. Then, the motor 69 of the lifting mechanism 67 is driven to move the lifter LF4 downward to the first height position P1. Accordingly, the in-tank carrier 47 is made grasped only by the one-paired operating shafts 57a.

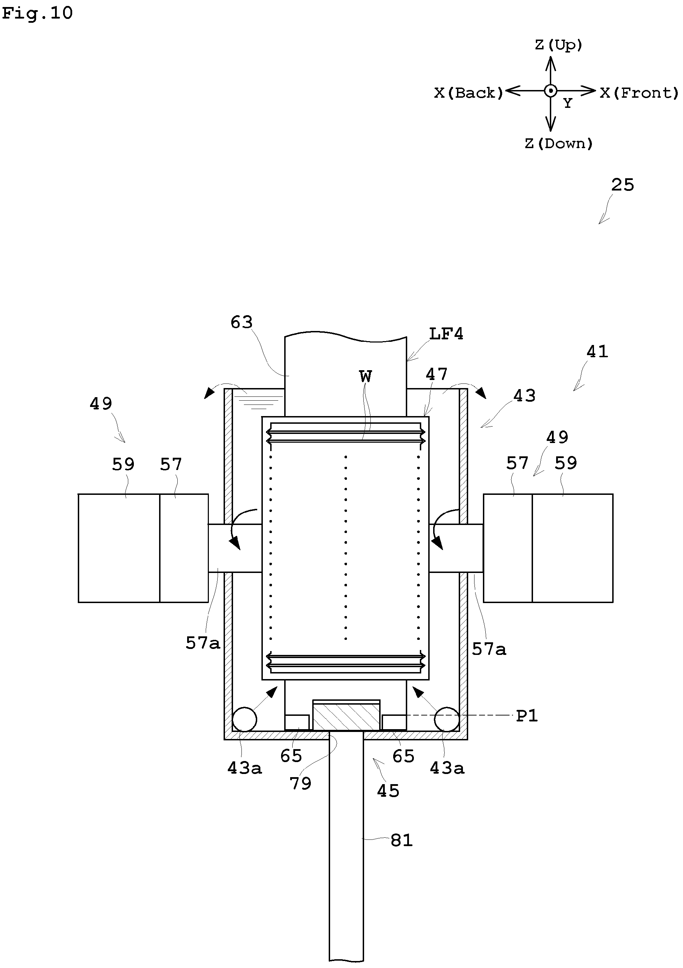

Reference is made to Fig. 10. The rotating mechanism 49 of the posture turning unit 41 is actuated. Specifically, the motor 59 of the rotating mechanism 49 is driven to rotate the in-tank carrier 47 together with the air cylinder 57 around an axis in the front-back direction X. In other words, the motor 59 is rotated to turn the in-tank carrier 47 counterclockwise seen from the deionized water processing unit ONB. A rotation angles is 90 degrees. Accordingly, the in-tank carrier 47 turns from a lateral (horizontal) posture to a longitudinal (vertical) posture. As a result, the posture of the substrates W turns from the vertical posture to the horizontal posture. At this time, the substrates W are kept immersed in the deionized water in the immersion tank 43. No part of the substrates W are exposed from the deionized water when the posture thereof turns.

As described above, the one-paired operating shaft 57a at the connecting position are rotated by the rotating mechanism 49, whereby the in-tank carrier 47 can be rotated to turn the posture of the substrates W to the horizontal posture collectively. Accordingly, the posture of the substrates W can be turned with a simple configuration, leading to suppressed apparatus costs.

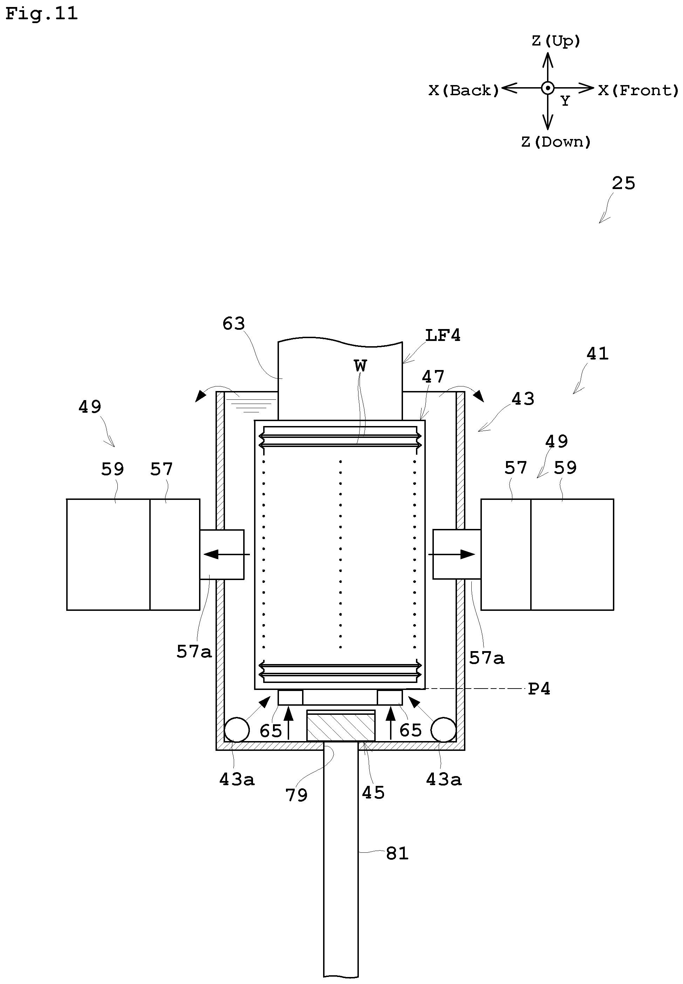

Reference is made to Fig. 11. The lifting mechanism 67 causes the lifter LF4 to move upward to the fourth height position P4. Accordingly, the holder 65 of the lifter LF4 holds the in-tank carrier 47 in the longitudinal posture in the liquid. Moreover, the air cylinder 57 shrinks to move the operating shafts 57a to the opened position. Accordingly, the in-tank carrier 47 is held only with the lifter LF4.

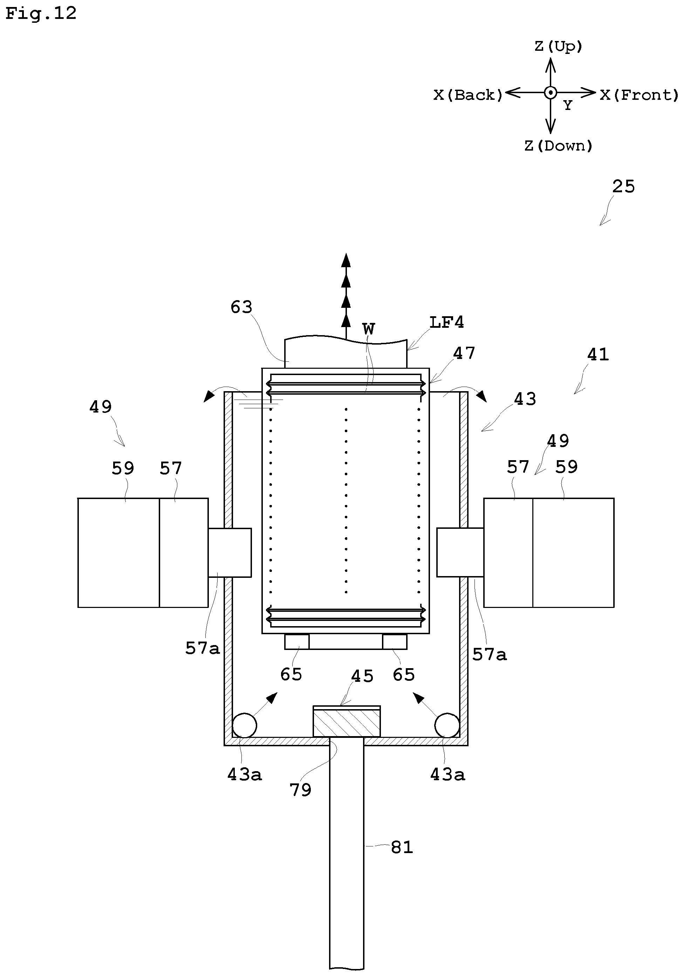

Reference is made to Fig. 12. The lifting mechanism 67 causes the lifter LF4 to move upward from the fourth height position P4 to a position where only an uppermost substrate W in the in-tank carrier 47 is exposed from the liquid level. The substrate W is to be transported by the center robot CR. Accordingly, the uppermost substrate W is exposed above the liquid level of the immersion tank 43 while the deionized water stored in the immersion tank 43 covers an upper part thereof. In such a condition, the center robot CR advances the hands 29 into the in-tank carrier 47 to unload the uppermost substrate W.

When the center robot CR moves to the underwater posture turning unit 25 for transporting a next substrate W, the lifting mechanism 67 moves the lifter LF4 further upward. Specifically, the lifter LF4 is moved upward by a gap between grooves of the in-tank carrier 47. Accordingly, only the next substrate W is exposed above the liquid level of the immersion tank 43. In such a condition, the center robot CR unloads the substrate W. As described above, the lifting mechanism 67 moves the lifter LF4 upward gradually each time the center robot CR comes. Accordingly, all the substrates W are transported by the center robot CR while they are wet with the deionized water.

As described above, substrates W not to be transported by the center robot CR are positioned below the liquid level of the immersion tank 43. Accordingly, the substrates W can be prevented from being dried until the substrates W are to be transported by the center robot CR. This results in suppressed pattern collapse of the substrates W.

### <7-3. Single-wafer treatment>

The substrates W transported by the center robot CR in such a manner as described above are treated as under, for example.

The center robot CR transports the substrates W to the first single-wafer processing unit SWP1. The first single-wafer processing unit SWP1 supplies deionized water from the nozzle 35 while the rotating unit 33 rotates the substrates W, for example. Then, the nozzle 35 supplies IPA to the substrates W and the deionized water adhered to the substrates W are replace by the IPA. Then, the center robot CR unloads the substrates W to the third single-wafer processing unit SWP3. In the third single-wafer processing unit SWP3, the substrates W are loaded into the supercritical fluid chamber 37. In the supercritical fluid chamber 37, dry treatment is performed on the substrates W with carbon dioxide. By the dry treatment in the supercritical fluid chamber 37, finishing dry treatment is performed on the substrates W. This completely dries the substrates W while suppressing collapse of the patterns formed on the substrates W.

The substrates W subjected to the treatment in the supercritical fluid chamber 37 are transported to the buffer unit 31 by the center robot CR. The center robot CR places the substrates W on the mount shelf 39 of the buffer unit 31. When one lot of substrates W are placed in the buffer unit 31, the first transport mechanism HTR transports the substrates W to the transporting and accommodating unit ACB at one time. The transporting and accommodating unit ACB transports the substrates W together with the carrier C to the unloading unit 13. The single-wafer treatment and the transportation thereafter described above are performed on all the substrates W in the in-tank carrier 47. This allows performance of the batch treatment and the single-wafer treatment on all of the substrates W.

With this embodiment, the substrates W on which the treatment is performed by the batch-type processing unit are transported to the posture turning unit 41 by the second transport mechanism WTR. At this time, the substrates W are immersed in the deionized water in the immersion tank 43 until the posture thereof is turned. Accordingly, the substrates W can entirely be made wet constantly when the posture thereof is turned from the vertical posture to the horizontal posture. As a result, pattern collapse in the substrates W can be suppressed even when the substrates W are transported by the center robot CR for performing single-wafer treatment.

Now the pattern collapse is suppressible, leading to no need to retreatment such as pattern removal of the substrates W with collapsed patterns. This results in a suppressed usage amount of the chemical and the deionized water. Moreover, power consumption in the substrate treating apparatus 1 required to complete treatment on the same number of substrates W can be suppressed.

### <Modification>

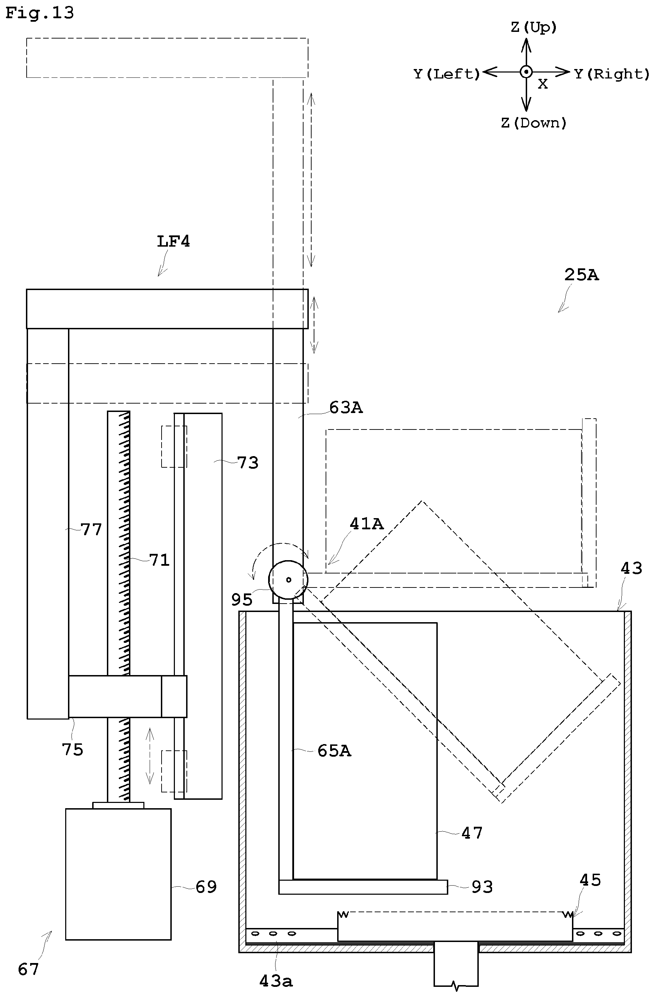

The underwater posture turning unit 25 described above causes the posture turning unit 41 to turn the posture of the in-tank carrier 47 from the lateral posture to the longitudinal posture, thereby changing the posture of the substrates W from the vertical posture to the horizontal posture. However, an underwater posture turning unit 25A may be configured as under. Reference is now made to Fig. 13. Fig. 13 is a side view of an underwater posture turning unit according to one modification.

The underwater posture turning unit 25A includes a posture turning unit 41A. The lifter LF4 includes a back plate 63A, supporting portions 65A, a short-side supporting portion 93, and a supporting portion driving unit 95. The posture turning unit 41A includes the supporting portion driving unit 95.

The short-side supporting portion 93 is attached to a part of the supporting portion 65A opposite to the back plate 63A. The short-side supporting portion 93 supports a short side of the in-tank carrier 37. The supporting portion driving unit 95 is provided at a lower end of the back plate 63A. The supporting portion driving unit 95 includes a motor. The motor has a rotary shaft directed laterally. The rotary shaft is directed along the front-back direction X.

The supporting portion driving unit 95 drives the supporting portion 65A together with the short-side supporting portion 93. Specifically, the supporting portion driving unit 95 drives the supporting portion 65A between a state where the supporting portion 65A is in a horizontal posture directed in the transverse direction Y (shown by chain double-dashed lines in Fig. 13) and a state where the supporting portion 65A is in a vertical posture directed in the vertical direction Z (shown by solid lines in Fig. 13). Fig. 13 shows by dotted lines a middle state where the posture turns between the horizontal posture and the vertical posture.

In the posture turning unit 41A in such a state as above, firstly the supporting portion 65A is brought into a horizontal posture (shown by chain double-dashed lines in Fig. 13), and then receives the substrates W from the second transport mechanism WTR in the in-tank carrier 47. Then, the supporting portion driving unit 95 is driven to bring the supporting portion 65A into a vertical posture (shown by solid lines in Fig. 13). Accordingly, the supporting portion 65A is brought into the vertical posture in the liquid. When the substrates W are delivered to the center robot CR, the lifting mechanism 67 may move the lifter LF4 upward in the vertical direction Z gradually.

The posture turning unit 41A described as above can perform posture turning while the in-tank carrier 47 moves downward. Accordingly, the posture of the substrates W can be turned rapidly. This results in enhanced throughput.

The present invention is not limited to the foregoing examples, but may be modified as follows.
(1) In the embodiment described above, the in-tank carrier 47 moves upward relative to the immersion tank 43 when the substrates W are delivered to the center robot CR. However, such an embodiment is not limitative in the present invention. For example, the immersion tank 43 may move downward relative to the in-tank carrier 47.
(2) In the embodiment described above, the posture turning unit 41 includes the in-tank carrier 47. However, the in-tank carrier 47 is not essential in the present invention. For example, a plurality of grooves are formed in the supporting portions 65 of the lifter LF4 and the substrates W are supported by the supporting portions 65. Such a configuration is adoptable. In this case, the supporting portion driving unit 95 as shown in Fig. 13 may turn the posture of the substrates W.
(3) In the embodiment described above, the substrate treating apparatus 1 includes the chemical processing unit CHB2 and the deionized water processing unit ONB as the batch-type processing unit. However, the present invention is not limitative to the batch-type processing unit.
(4) In the embodiment described above, the substrate treating apparatus 1 includes the first single-wafer processing unit SWP1 and the second single-wafer processing unit SWP2 for performing treatment with deionized water and IPA, and includes the supercritical chamber 37 as the third single-wafer processing unit SWP3. However, the present invention is not limitative to the single-wafer-type processing unit.
(5) In the embodiment described above, the posture turning unit 41 is located externally of the immersion tank 43. However, such an aspect is not limitative in the present invention. That is, a posture turning unit 41 having waterproofness may be provided inside of the immersion tank 43.
(6) In the embodiment described above, the underwater posture turning unit 25 moves the substrates W one by one upward from the liquid level. However, such an aspect is not limitative in the present invention. That is, when the center robot CR includes the two hands 29, the underwater posture turning unit 25 may move two substrates W at a time from the liquid level. In other words, the numbers of substrates W moved upward from the liquid level may correspond to the number of the hands 29 of the center robot CR.
(7) In the embodiment described above, such a substrate treating apparatus 1 has been described as an example that has the configuration shown in Fig. 1. However, the present invention is not limitative to this configuration. That is, the stocker block 5, the first transport mechanism HTR, and the transferring mechanism CTC are not essential.

## Claims

1. A substrate treating apparatus (1) that performs treatment on a substrate (W), the apparatus (1) comprising:
a batch-type processing unit (BPU1, BPU2, BPU3) configured to perform treatment on a plurality of substrates (W) in a vertical posture collectively;
a single-wafer-type processing unit (SWP1, SWP2, SWP3) configured to perform treatment on one substrate (W) of the substrates (W) in a horizontal posture;
a posture turning unit (41) configured to hold the substrates (W) on which the treatment is performed by the batch-type processing unit (BPU1, BPU2, BPU3), and to turn a posture of the substrates (W) from vertical to horizontal within an immersion tank (43);
a first transport unit (WTR) configured to transport the substrates (W), on which the treatment is performed by the batch-type processing unit (BPU1, BPU2, BPU3), to the posture turning (41) unit;
a second transport unit (CR) configured to transport the substrates (W), turned to horizontal by the posture turning unit (41), to the single-wafer-type processing unit (SWP1, SWP2, SWP3); and
the immersion tank (43) configured to accommodate the substrates (W) whose posture is to be turned by the posture turning unit (41), and in which the substrates (W) are immersed in deionized water before the posture is turned,
a lifting mechanism (67) configured to move the substrates (W) in the horizontal posture upward and downward relative to the immersion tank (43), wherein
only a target substrate (W) to be transported among the substrates (W) is moved above a liquid level of the immersion tank (43) when the second transport unit (CR) receives the substrate (W) to be transported,
wherein the substrate treating apparatus (1) includes:
an in-tank carrier (47) configured to accommodate the substrates (W) in such a manner that faces of the substrates (W) are directed orthogonal with respect to a predetermined alignment direction; and
a rotating mechanism (49) configured to rotate the in-tank carrier (47) around a horizontal axis orthogonal with respect to the alignment direction under the liquid level of the immersion tank (43),
the lifting mechanism (67) includes
a lifter (LF4) having a back plate (63) extending along an inner surface of the immersion tank (43) and a supporting portion (65) provided at a lower end of the back plate (63) along a horizontal direction and configured to support the in-tank carrier (47), and
the lifter (LF4) moves among a sinking position (P2) where the in-tank carrier (47) is entirely supported under the liquid level of the immersion tank (43), a rotating position (P1), below the sinking position (P2), where the supporting portion (65) is spaced apart from a lower face of the in-tank carrier (47), a delivery position (P3) where the substrates (W) are delivered to and from the first transport unit (WTR), and a transport position (P3) where only the target substrate (W) to be transported is located above the liquid level of the immersion tank (43),
the in-tank carrier (47) has an opening (51) at a bottom face thereof,
the lifter (LF4) being located at a position where the supporting portion (65) does not close the opening (51),
a pusher (45) configured to support lower edges of the substrates (W), having a shape not interfering with the opening (51) and the supporting portion (65), and configured to move upward and downward between a standby position below the in-tank carrier (47) and at a bottom of the immersion tank (43) and a transferring position, above the liquid level of the immersion tank (43), where the substrates (W) are delivered to and from the first transport unit (WTR), and
when the first transport unit (WTR) transports the substrates (W) to the posture turning unit (41), the pusher (45) is moved upward to the transferring position and receives the substrates (W), and thereafter the pusher (45) is moved downward to the standby position and delivers the substrates (W) to the in-tank carrier (47).

2. The substrate treating apparatus (1) according to claim 1, wherein
the rotating mechanism (49) includes
one-paired rotary shafts (57a) that are movable between a connecting position where the one-paired rotary shafts (57a) are connected to a side face of the in-tank carrier (47) orthogonal to the alignment direction and an opened position where the one-paired rotary shafts (57a) are spaced apart from the side face, and
a rotation drive unit (59) configured to rotate the one-paired rotary shafts (57a) at the connecting position to turn a posture of the substrates (W) in the in-tank carrier (47).

3. The substrate treating apparatus (1) according to claim 2, further comprising:
an advancing and withdrawing drive mechanism (57) configured to move the one-paired rotary shafts (57a) between the connecting position and the opened position, wherein
the rotation drive unit (59) turns a posture of the substrates (W) in the in-tank carrier (47) while the advancing and withdrawing drive mechanism (57) advances the one-paired rotary shafts (57a) to the connecting position and moves the lifter (LF4) to the rotating position (P1).

4. The substrate treating apparatus (1) according to one of the claims 1 to 3, wherein
the single-wafer-type processing unit (SWP3) is a supercritical fluid chamber (37) configured to perform dry treatment with supercritical fluid.

## Patentansprüche

1. Substratbehandlungsvorrichtung (1), die eine Behandlung an einem Substrat (W) durchführt, wobei die Vorrichtung (1) umfasst:
eine Batch-Typ-Verarbeitungseinheit (BPU1, BPU2, BPU3), die eingerichtet ist, eine Behandlung an einer Vielzahl von Substraten (W) in einer vertikalen Stellung kollektiv durchzuführen;
eine Einzelwafer-Typ-Verarbeitungseinheit (SWP1, SWP2, SWP3), die eingerichtet ist, eine Behandlung an einem Substrat (W) der Substrate (W) in einer horizontalen Stellung durchzuführen;
eine Stellung-Dreheinheit (41), die eingerichtet ist, die Substrate (W), an denen die Behandlung durch die Batch-Typ-Verarbeitungseinheit (BPU1, BPU2, BPU3) durchgeführt wird, zu halten und eine Stellung der Substrate (W) innerhalb eines Immersionstanks (43) von vertikal zu horizontal zu drehen;
eine erste Transporteinheit (WTR), die eingerichtet ist, die Substrate (W), an denen die Behandlung durch die Batch-Typ-Verarbeitungseinheit (BPU1, BPU2, BPU3) durchgeführt wird, zu der Stellung-Dreheinheit (41) zu transportieren;
eine zweite Transporteinheit (CR), die eingerichtet ist, die durch die Stellung-Dreheinheit (41) in die horizontale Stellung gedrehten Substrate (W) zu der Einzelwafer-Typ-Verarbeitungseinheit (SWP1, SWP2, SWP3) zu transportieren; und
den Immersionstank (43), der eingerichtet ist, die Substrate (W), deren Stellung durch die Stellung-Dreheinheit (41) zu drehen ist, aufzunehmen, und in dem die Substrate (W) vor dem Drehen der Stellung in deionisiertes Wasser eingetaucht werden,
einen Hebemechanismus (67), der eingerichtet ist, die Substrate (W) in der horizontalen Stellung relativ zu dem Immersionstank (43) nach oben und unten zu bewegen, wobei
nur ein zu transportierendes Zielsubstrat (W) unter den Substraten (W) über einen Flüssigkeitspegel des Immersionstanks (43) bewegt wird, wenn die zweite Transporteinheit (CR) das zu transportierende Substrat (W) aufnimmt,
wobei die Substratbehandlungsvorrichtung (1) umfasst:
einen Innentankträger (47), der eingerichtet ist, die Substrate (W) derart aufzunehmen, dass Flächen der Substrate (W) orthogonal zu einer vorbestimmten Ausrichtungsrichtung gerichtet sind; und
einen Drehmechanismus (49), der eingerichtet ist, den Innentankträger (47) um eine horizontale Achse, die orthogonal zu der Ausrichtungsrichtung ist, unter dem Flüssigkeitspegel des Immersionstanks (43) zu drehen,
wobei der Hebemechanismus (67) umfasst:
einen Heber (LF4) mit einer Rückplatte (63), die sich entlang einer Innenfläche des Immersionstanks (43) erstreckt, und einem Stützabschnitt (65), der an einem unteren Ende der Rückplatte (63) entlang einer horizontalen Richtung vorgesehen und eingerichtet ist, den Innentankträger (47) zu stützen, und
sich der Heber (LF4) zwischen einer Absenkposition (P2), in der der Innentankträger (47) vollständig unter dem Flüssigkeitspegel des Immersionstanks (43) gestützt wird, einer Drehposition (P1) unterhalb der Absenkposition (P2), in der der Stützabschnitt (65) von einer Unterfläche des Innentankträgers (47) beabstandet ist, einer Übergabeposition (P3), in der die Substrate (W) an die erste Transporteinheit (WTR) und von dieser übergeben werden, und einer Transportposition (P3), in der nur das zu transportierende Zielsubstrat (W) über dem Flüssigkeitspegel des Immersionstanks (43) angeordnet ist, bewegt,
wobei der Innentankträger (47) eine Öffnung (51) an einer Bodenfläche davon aufweist,
wobei der Heber (LF4) an einer Position angeordnet ist, an der der Stützabschnitt (65) die Öffnung (51) nicht verschließt,
einen Drücker (45), der eingerichtet ist, untere Kanten der Substrate (W) zu stützen, der eine Form aufweist, die nicht mit der Öffnung (51) und dem Stützabschnitt (65) interferiert, und der eingerichtet ist, sich zwischen einer Bereitschaftsposition unterhalb des Innentankträgers (47) und an einem Boden des Immersionstanks (43) und einer Übergabeposition oberhalb des Flüssigkeitspegels des Immersionstanks (43), in der die Substrate (W) an die erste Transporteinheit (WTR) und von dieser übergeben werden, nach oben und unten zu bewegen, und
wenn die erste Transporteinheit (WTR) die Substrate (W) zu der Stellung-Dreheinheit (41) transportiert, der Drücker (45) zu der Übergabeposition nach oben bewegt wird und die Substrate (W) übernimmt und danach der Drücker (45) zu der Bereitschaftsposition nach unten bewegt wird und die Substrate (W) an den Innentankträger (47) übergibt.

2. Substratbehandlungsvorrichtung (1) nach Anspruch 1, wobei
der Drehmechanismus (49) umfasst:
ein Paar von Drehwellen (57a), die zwischen einer Verbindungsposition, in der das Paar von Drehwellen (57a) mit einer Seitenfläche des Innentankträgers (47) verbunden ist, die orthogonal zu der Ausrichtungsrichtung ist, und einer geöffneten Position, in der das Paar von Drehwellen (57a) von der Seitenfläche beabstandet ist, bewegbar sind, und
eine Dreh-Antriebseinheit (59), die eingerichtet ist, das Paar von Drehwellen (57a) in der Verbindungsposition zu drehen, um eine Stellung der Substrate (W) in dem Innentankträger (47) zu drehen.

3. Substratbehandlungsvorrichtung (1) nach Anspruch 2, ferner umfassend:
einen Vorschub- und Rückzugsantriebsmechanismus (57), der eingerichtet ist, das Paar von Drehwellen (57a) zwischen der Verbindungsposition und der geöffneten Position zu bewegen, wobei
die Dreh-Antriebseinheit (59) eine Stellung der Substrate (W) in dem Innentankträger (47) dreht, während der Vorschub- und Rückzugsantriebsmechanismus (57) das Paar von Drehwellen (57a) zu der Verbindungsposition vorschiebt und den Heber (LF4) zu der Drehposition (P1) bewegt.

4. Substratbehandlungsvorrichtung (1) nach einem der Ansprüche 1 bis 3, wobei
die Einzelwafer-Typ-Verarbeitungseinheit (SWP3) eine überkritische Fluidkammer (37) ist, die eingerichtet ist, eine Trockenbehandlung mit überkritischem Fluid durchzuführen.

## Revendications

1. Appareil de traitement de substrat (1) qui effectue un traitement sur un substrat (W), l'appareil (1) comprenant :
une unité de traitement de type par lots (BPU1, BPU2, BPU3) configurée pour effectuer collectivement un traitement sur une pluralité de substrats (W) en orientation verticale ;
une unité de traitement de type à substrat unique (SWP1, SWP2, SWP3) configurée pour effectuer un traitement sur un substrat (W) des substrats (W) en orientation horizontale ;
une unité de changement d'orientation (41) configurée pour maintenir les substrats (W) sur lesquels le traitement est effectué par l'unité de traitement de type par lots (BPU1, BPU2, BPU3), et pour changer l'orientation des substrats (W) de verticale à horizontale dans une cuve d'immersion (43) ;
une première unité de transport (WTR) configurée pour transporter les substrats (W), sur lesquels le traitement est effectué par l'unité de traitement de type par lots (BPU1, BPU2, BPU3), vers l'unité de changement d'orientation (41) ;
une seconde unité de transport (CR) configurée pour transporter les substrats (W), mis à l'horizontale par l'unité de changement d'orientation (41), vers l'unité de traitement de type à substrat unique (SWP1, SWP2, SWP3) ; et
la cuve de d'immersion (43) configurée pour accueillir les substrats (W) dont l'orientation doit être changée par l'unité de changement d'orientation (41), et dans lequel les substrats (W) sont immergés dans de l'eau désionisée avant que l'orientation ne soit changée,
un mécanisme de levage (67) étant configuré pour déplacer les substrats (W) en orientation horizontale vers le haut et vers le bas par rapport à la cuve d'immersion (43), dans lequel
seul un substrat cible (W) à transporter parmi les substrats (W) est déplacé au-dessus d'un niveau de liquide de la cuve d'immersion (43) lorsque la seconde unité de transport (CR) reçoit le substrat (W) à transporter,
dans lequel l'appareil de traitement de substrat (1) comprend :
un support interne à la cuve (47) configuré pour accueillir les substrats (W) de sorte que les faces des substrats (W) soient orientées orthogonalement par rapport à une direction d'alignement prédéterminée ; et
un mécanisme de rotation (49) configuré pour faire tourner le support interne à la cuve (47) autour d'un axe horizontal orthogonal par rapport à la direction d'alignement sous le niveau de liquide de la cuve d'immersion (43),
le mécanisme de levage (67) comprend
un dispositif de levage (LF4) ayant une plaque arrière (63) s'étendant le long d'une surface intérieure de la cuve d'immersion (43) et une partie de soutien (65) prévue au niveau d'une extrémité inférieure de la plaque arrière (63) dans une direction horizontale et configurée pour soutenir le support interne à la cuve (47), et
le dispositif de levage (LF4) se déplace entre une position d'enfoncement (P2) où le support interne à la cuve (47) est entièrement soutenu sous le niveau de liquide de la cuve d'immersion (43), une position de rotation (P1), en dessous de la position d'enfoncement (P2), où la partie de soutien (65) est espacée d'une face inférieure du support interne à la cuve (47), une position de distribution (P3) où les substrats (W) sont distribués vers et depuis la première unité de transport (WTR), et une position de transport (P3) où seul le substrat cible (W) à transporter est situé au-dessus du niveau de liquide de la cuve d'immersion (43),
le support interne à la cuve (47) a une ouverture (51) au niveau de sa face inférieure,
le dispositif de levage (LF4) étant situé dans une position où la partie de soutien (65) ne ferme pas l'ouverture (51),
un poussoir (45) configuré pour soutenir les bords inférieurs des substrats (W), ayant une forme n'interférant pas avec l'ouverture (51) et la partie de soutien (65), et configuré pour se déplacer vers le haut et vers le bas entre une position d'attente sous le support interne à la cuve (47) et au fond de la cuve d'immersion (43) et une position de transfert, au-dessus du niveau de liquide de la cuve d'immersion (43), où les substrats (W) sont distribués vers et depuis la première unité de transport (WTR), et
lorsque la première unité de transport (WTR) transporte les substrats (W) vers l'unité de changement d'orientation (41), le poussoir (45) est déplacé vers le haut jusqu'à la position de transfert et reçoit les substrats (W), puis le poussoir (45) est déplacé vers le bas jusqu'à la position d'attente et distribue les substrats (W) vers le support interne à la cuve (47).

2. Appareil de traitement de substrat (1) selon la revendication 1, dans lequel
le mécanisme de rotation (49) comprend
des arbres rotatifs appariés (57a) qui sont mobiles entre une position de liaison où les arbres rotatifs appariés (57a) sont reliés à une face latérale du support interne à la cuve (47) orthogonale à la direction d'alignement et une position ouverte où les arbres rotatifs appariés (57a) sont espacés de la face latérale, et
une unité d'entraînement en rotation (59) configurée pour faire tourner les arbres rotatifs appariés (57a) à la position de liaison pour changer l'orientation des substrats (W) dans le support interne à la cuve (47).

3. Appareil de traitement de substrat (1) selon la revendication 2, comprenant en outre :
un mécanisme d'entraînement d'avance et de retrait (57) configuré pour déplacer les arbres rotatifs appariés (57a) entre la position de liaison et la position ouverte, dans lequel
l'unité d'entraînement en rotation (59) change l'orientation des substrats (W) dans le support interne à la cuve (47) tandis que le mécanisme d'entraînement d'avance et de retrait (57) fait avancer les arbres rotatifs appariés (57a) jusqu'à la position de liaison et déplace le dispositif de levage (LF4) jusqu'à la position de rotation (P1).

4. Appareil de traitement de substrat (1) selon l'une des revendications 1 à 3, dans lequel
l'unité de traitement de type à substrat unique (SWP3) est une chambre à fluide supercritique (37) configurée pour effectuer un traitement à sec avec un fluide supercritique.
